# EUROPÄISCHE PATENTSCHRIFT

(11) **EP 2 865 869 B1**
(45) Veröffentlichungstag und Bekanntmachung des Hinweises auf die Patenterteilung: **17.01.2018**
(21) Anmeldenummer: 14003560.1
(22) Anmeldetag: 17.10.2014
(51) Int. Cl.: F02D 29/06, G05B 23/02, G01R 31/40, G01R 31/02

(54) **Verfahren zum Betreiben einer mit einem Energieversorgungsnetz verbundenen Kraftanlage**
Method for operating a power plant connected to an energy supply network
Procédé de fonctionnement d'une centrale reliée à un réseau d'alimentation électrique

(30) Priorität: 23.10.2013 AT 8192013
(43) Veröffentlichungstag der Anmeldung: 29.04.2015
(73) Patentinhaber: GE Jenbacher GmbH & Co OG, 6200 Jenbach (AT)
(72) Erfinder: Gomez, Josè, 72764 Reutlingen (DE); Kruckenhauser, Erich, 6232 Münster (AT)
(74) Vertreter: Torggler & Hofinger Patentanwälte

(56) Entgegenhaltungen:
- JP-A- 2006 090 173
- JP-A- 2008 050 985
- JP-A- 2009 203 882
- JP-A- 2011 010 377

## Beschreibung

Die Erfindung betrifft ein Verfahren zum Betreiben einer mit einem Energieversorgungsnetz verbundenen, stationären Kraftanlage (Stromerzeugungsanlage), wobei bei Auftreten eines dynamischen Netzfehlers im Energieversorgungsnetz, insbesondere eines elektrischen Kurzschlusses, wenigstens ein Fehlerwert in Abhängigkeit von einem Zustandswert wenigstens einer Betriebsgröße der Kraftanlage ermittelt wird.

Dynamische Netzfehler, insbesondere elektrische Kurzschlüsse, in Energieversorgungsnetzen (z.B. einem öffentlichen Netz) können hohe Belastungen in mit dem Energieversorgungsnetz verbundenen Komponenten verursachen. Unter dynamischen Netzfehlern versteht man Spannungseinbrüche oder -schwankungen im Bereich von wenigen 100 Millisekunden (ms) bis zum Beispiel weniger als 700 ms, bevorzugt weniger als 500 ms.

Im Netzparallelbetrieb gibt das Energieversorgungsnetz die Sollspannung und die Sollfrequenz, sowie die Phase der Wechselspannung des Wechselstromgenerators vor.

Insbesondere bei einer mit einem Energieversorgungsnetz im Netzparallelbetrieb verbundenen Kraftanlage verursachen Kurzschlüsse hohe Stormstärken in den mit dem Energieversorgungsnetz verbundenen Statorwicklungen eines elektrischen Generators der Kraftanlage, welche in weiterer Folge auch zu hohen Stromflüssen in den Rotorwicklungen des Generators führen können. Darüber hinaus verursachen hohe Kurzschlussströme eine Erhöhung des Drehmoments, welches auf die mit dem Rotor verbundene Generatorwelle wirkt. Die Generatorwelle ist üblicherweise mittels einer Kupplungsvorrichtung mit der Motorwelle einer Brennkraftmaschine verbunden, wodurch ein solcherart hervorgerufenes Drehmoment über die Kupplungsvorrichtung auf die Brennkraftmaschine übertragen werden kann und in der Brennkraftmaschine unerwünschte Vibrationen und Oszillationen hervorrufen kann.

Um solchen Netzfehlern entgegenzuwirken und die Stabilität einer Kraftanlage während und nach dem Netzfehler zu begünstigen, kann eine Regelvorrichtung für die Brennkraftmaschine vorgesehen sein, die entsprechende Gegenmaßnahmen trifft. So kann vorgesehen sein, dass die Synchronizität des Generators mit dem Energieversorgungsnetz aufrecht erhalten wird, indem die mechanische Leistung der mit dem Generator verbundenen Brennkraftmaschine entsprechend der elektrischen Leistung, die vom Generator an das Energieversorgungsnetz abgegeben werden kann, angepasst wird. Dies kann beispielweise durch Anpassungen des Verbrennungsvorganges, wie beispielsweise eine Verzögerung oder Unterbrechung der Zündung oder eine Stellungsänderung von entsprechenden Aktuatoren der Brennkraftmaschine (zum Beispiel Drosselklappe oder Brennstoffdosierventil) erfolgen.

Um Schäden an der Kraftanlage infolge von Netzfehlern, insbesondere elektrischen Kurzschlüssen, zu verhindern oder zu minimieren, wird üblicherweise in Wartungsplänen festgelegt, dass nach einer gewissen Anzahl von aufgetretenen Kurzschlüssen eine Wartung erfolgt. Dabei wird jedoch nicht unterschieden, ob es sich beim aufgetretenen Netzfehler bzw. Kurzschluss um einen schwerwiegenden Netzfehler oder nur um einen geringfügigen Netzfehler gehandelt hat. Auch die Reaktion der Kraftanlage bzw. ihrer Bestandteile (z.B. Generator, Kupplung, Brennkraftmaschine) auf den Netzfehler wird bei bisher bekannten Wartungsplänen nicht berücksichtigt. Dadurch kann es vorkommen, dass ein Wartungsplan die Wartung der Kraftanlage unmittelbar nach einem Fehler vorsieht, obwohl es sich beim aufgetretenen Fehler nur um einen geringfügigen Netzfehler gehandelt hat, der kaum Auswirkungen auf die Kraftanlage hatte. Andererseits kann es auch vorkommen, dass ein Wartungsplan die Wartung der Kraftanlage erst nach Auftreten von mehreren elektrischen Kurzschlüssen vorsieht, wobei bereits der erste aufgetretene Netzfehler ein hohes Schadenpotential hatte. Darüber hinaus mangelt es bekannten Wartungsplänen auch daran, Aussagen über die zu untersuchenden Bauteile der Kraftanlage bei der nächsten Wartung zu treffen.

JP 2011 010377 A offenbart ein Verfahren, wobei eine Wartung einer Kraftanlage mithilfe der Überwachung des Verhältnisses zwischen der elektrischen Spannung Vdc des Generators und dem Größenwert N/c (N=Motordrehzahl, c=fester Koeffizient) festgestellt wird.

Aufgabe der Erfindung ist es daher, die vorbeschriebenen Nachteile zu vermeiden und ein gegenüber dem Stand der Technik verbessertes Verfahren zum Betreiben einer mit einem Energieversorgungsnetz verbundenen Kraftanlage bei Auftreten eines Netzfehlers anzugeben. Insbesondere soll dadurch erreicht werden, dass die Ausgabe einer spezifischen und/oder qualitativen Wartungsempfehlung ermöglicht wird.

Diese Aufgabe wird erfindungsgemäß durch die Merkmale des Patentanspruchs 1 gelöst. Vorteilhafte Ausgestaltungen der Erfindung sind in den abhängigen Patentansprüchen angegeben.

Gemäß der Erfindung ist also vorgesehen, dass der wenigstens eine Fehlerwert wenigstens einem Bestandteil der Kraftanlage zugeordnet wird, wobei ein Wartungssignal für den wenigstens einen Bestandteil der Kraftanlage in Abhängigkeit vom wenigstens einen Fehlerwert ausgegeben wird.

Durch das Abfragen von Zustandswerten von Betriebsgrößen der Kraftanlage, das Bestimmen von Fehlerwerten in Abhängigkeit von den Zustandswerten und das vorgeschlagene Zuordnen der Fehlerwerte zu Bestandteilen der Kraftanlage können zum einen Betriebsgrößen bzw. Bestandteile der Kraftanlage mit Auffälligkeiten erkannt werden und andererseits können abhängig von den Fehlerwerten bezüglich der Betriebsgrößen gezielte Wartungssignale für einzelne Bestandteile der Kraftanlage ermittelt und ausgegeben werden. Im Unterschied zu bekannten Wartungsplänen kann damit nicht allein auf die Anzahl von aufgetretenen Netzfehlern abgestellt werden, sondern es ist eine spezifische Aussage darüber möglich, ob nach einem aufgetretenen Netzfehler ein Bestandteil der Kraftanlage - und wenn ja welcher Bestandteil - zu warten ist.

Zur Ermittlung des wenigstens einen Fehlerwerts kann der Zustandswert der wenigstens einen Betriebsgröße der Kraftanlage vor dem Netzfehler und/oder während des Netzfehlers und/oder nach dem Netzfehler ermittelt werden.

Gemäß einer bevorzugten Ausführungsform kann vorgesehen sein, dass der Fehlerwert in Abhängigkeit vom Zustandswert der wenigstens einen Betriebsgröße und wenigstens einem vorgebbaren Referenzwert ermittelt wird. Bei einem Referenzwert kann es sich beispielsweise um einen Schwellwert handeln, wobei der Fehlerwert abhängig davon sein kann, ob der Zustandswert einer Betriebsgröße den Schwellwert überschreitet oder unterschreitet.

Bei den Betriebsgrößen kann es sich beispielsweise um eine oder mehrere der nachfolgend erläuterten Betriebsgrößen handeln.

Betriebsgrößen in Bezug auf die Zündung:
Infolge eines Netzfehlers, insbesondere Kurzschlusses, und um die Synchronität des Generators mit dem Energieversorgungsnetz aufrechtzuerhalten, kann eine Motorregelung der Brennkraftmaschine eine verzögerte oder unterbrochene Zündung vorsehen, um die Drehzahl der Brennkraftmaschine und des Generators und damit die Synchronizität des Generators mit dem Energieversorgungsnetz auf dem gewünschten Niveau zu halten.

Eine Unterbrechung oder Verzögerung der Zündung stellt jedoch einen abnormalen Betriebszustand dar und kann auch eine mögliche Ursache für unerwünschte Fehlzündungen sein.

Mögliche zu ermittelnde Zustandswerte von Betriebsgrößen in Bezug auf die Zündung können sein: das Auftreten einer Verzögerung des Zündzeitpunktes, das Auftreten einer Unterbrechung der Verbrennung, die Zeitdauer einer Unterbrechung der Verbrennung.

Betriebsgrößen in Bezug auf den Turbolader:
Bei einer mittels Turbolader aufgeladenen Brennkraftmaschine können plötzliche Zustandsänderungen des in die Brennräume einzubringenden Brennstoff-Luft-Gemischs und/oder plötzliche Zustandsänderungen des aus den Brennräumen ausströmenden Abgases zu einem Abdrosseln des Turboladers führen. Das Abdrosseln des Turboladers kann dabei zu einem Rückfluss des Brennstoff-Luft-Gemisches und in weiterer Folge zu einer unerwünschten Beschleunigung des Turboladers führen, z.B. durch eine Auffettung des Brennstoff-Luft-Gemisches während des Netzfehlers.

Mögliche zu ermittelnde Zustandswerte von Betriebsgrößen in Bezug auf den Turbolader können sein: das Auftreten einer Abdrosselung des Turboladers, die Zeitdauer einer Abdrosselung des Turboladers.

Betriebsgrößen in Bezug auf das Drehmoment:
Ein Kurzschluss im Energieversorgungsnetz und der damit verbundene hohe Strom in den Statorwicklungen eines mit dem Energieversorgungsnetz verbundenen elektrischen Generators können zu einem plötzlichen Drehmomentanstieg eines auf den Rotor des Generators wirkenden Drehmoments führen. Solche plötzlichen Drehmomentanstiege können sich negativ auf die mit dem Rotor des Generators verbundene Brennkraftmaschine bzw. auf eine zwischen Brennkraftmaschine und Generator angeordnete Kupplungsvorrichtung auswirken.

Mögliche zu ermittelnde Zustandswerte von Betriebsgrößen in Bezug auf das Drehmoment können sein: die Höhe des Drehmoments an der Generatorwelle, die Höhe des Drehmoments an der Kupplungsvorrichtung, die Höhe des Drehmoments an der Motorwelle.

Betriebsgrößen in Bezug auf die elektrische Spannung:
Infolge eines Kurzschlusses fällt die elektrische Spannung in wenigstens einer Phase eines üblicherweise dreiphasig ausgeführten Energieversorgungsnetzes.

Der niedrigste dabei auftretende Spannungswert und die Dauer des Spannungsabfalls können herangezogen werden, um den Schweregrad des Netzfehlers zu bestimmen.

Mögliche zu ermittelnde Zustandswerte von Betriebsgrößen in Bezug auf die elektrische Spannung können sein: die Höhe der elektrischen Spannung des Generators, das Auftreten eines Spannungsabfalls, die Zeitdauer eines Spannungsabfalls.

Betriebsgrößen in Bezug auf den elektrischen Strom:
Infolge eines Kurzschlusses kommt es zu einem Stromanstieg in wenigstens einer Phase eines üblicherweise dreiphasig ausgebildeten Energieversorgungsnetzes. Eine hohe Stromstärke erhöht dabei die thermische Belastung der elektrischen Komponenten und kann zu hohen elektromagnetischen Kräften führen, die zu Beschädigungen führen können.

Mögliche zu ermittelnde Zustandswerte von Betriebsgrößen in Bezug auf den elektrischen Strom können sein: die Höhe des elektrischen Stroms des Generators, das Auftreten einer Stromstärkenerhöhung, die Zeitdauer einer Stromstärkenerhöhung.

Betriebsgrößen in Bezug auf die elektrische Wirkleistung:
Da die Wirkleistung über die Drehzahl mit dem Drehmoment in Zusammenhang steht, kann alternativ oder zusätzlich zur Auswertung des Drehmomentes auch die Wirkleistung herangezogen werden. Die elektrische Wirkleistung kann dabei aus Spannungs-, Strom- und Leistungsfaktormessungen ermittelt werden und ist proportional zum Drehmoment.

Mögliche zu ermittelnde Zustandswerte von Betriebsgrößen in Bezug auf die elektrische Wirkleistung können sein: die Höhe der von der Kraftanlage bzw. vom Generator der Kraftanlage an das Energieversorgungsnetz abgegebenen elektrischen Wirkleistung.

Betriebsgrößen in Bezug auf die Drehzahl:
Während eines Kurzschlusses kommt es durch das Ungleichgewicht zwischen der von der Brennkraftmaschine auf den Generator eingebrachten mechanischen Leistung und der vom Generator an das Energieversorgungsnetz abgegebenen elektrischen Leistung zu einer Abweichung der Drehzahl vom gewünschten Nenndrehzahlwert. Dabei können Schwankungen auftreten, die zu Belastungen von mit der Motorwelle der Brennkraftmaschine verbundenen mechanischen Komponenten (z.B. Kupplungsvorrichtung) führen können.

Mögliche zu ermittelnde Zustandswerte von Betriebsgrößen in Bezug auf die Drehzahl können sein: die Höhe der Drehzahl der Generatorwelle, die Höhe der Drehzahl der Kupplungsvorrichtung, die Höhe der Drehzahl der Motorwelle.

Betriebsgrößen in Bezug auf den Lastwinkel:
Als Lastwinkel wird bekannterweise der Winkel zwischen dem Vektor des rotierenden Magnetfeldes im Stator des Generators und dem Vektor des rotierenden Magnetfeldes im Rotor des Generators bezeichnet. Der Lastwinkel ist ein Maß für die elektrische Kupplung des Generators mit dem Energieversorgungsnetz und bestimmt die Leistungsfähigkeit der Abgabe von elektrischer Leistung an das Energieversorgungsnetz. Hohe Abweichungen des Lastwinkels vom erwünschten Nennwert können zu hohen elektromechanischen Kräften und Drehmomenten auf den Rotor des Generators und in weiterer Folge auf die Kupplungsvorrichtung und die Brennkraftmaschine bewirken.

Mögliche zu ermittelnde Zustandswerte von Betriebsgrößen in Bezug auf den Lastwinkel können sein: die Höhe des Lastwinkels, die Höhe des Lastwinkels nach Behebung des Netzfehlers.

Betriebsgrößen in Bezug auf den Erregerstrom:
Der Erregerstrom bestimmt die Höhe des Feldstroms in den Rotorwicklungen des Generators. Insbesondere durch Ankerrückwirkung kann es infolge eines Kurzschlusses zu einem stark erhöhten Erregerstrom und zu Beschädigungen der Wicklungsisolierung oder einer mit den Rotorwicklungen verbundenen Gleichrichterbrücke kommen. Die bei einem Kurzschluss erhöhten Statorströme in den Statorwicklungen des Generators induzieren entsprechend hohe Ströme in den Rotorwicklungen des Generators, die zu Beschädigungen der Wicklungsisolierung führen können. Die infolge eines durch einen Gleichrichter blockierten Stromflusses sich einstellende hohe Induktionsspannung kann wiederum zu Beschädigungen an Dioden im Gleichrichter führen.

Mögliche zu ermittelnde Zustandswerte von Betriebsgrößen in Bezug auf den Erregerstrom bzw. Erregerkreis können sein: die Höhe des Erregerstroms, die Zeitdauer einer bestimmten Erregerstromstärke.

Vorzugsweise kann vorgesehen sein, dass die Kraftanlage wenigstens einen der folgenden Bestandteile umfasst: einen mit dem Energieversorgungsnetz verbundenen elektrischen Generator, eine mit dem Generator verbundene Brennkraftmaschine, eine Kupplungsvorrichtung zur Verbindung einer drehbar gelagerten Generatorwelle des Generators mit einer drehbar gelagerten Motorwelle der Brennkraftmaschine, wobei wenigstens ein Fehlerwert in Abhängigkeit von einem Zustandswert wenigstens einer Betriebsgröße des Generators und/oder der Brennkraftmaschine und/oder der Kupplungsvorrichtung ermittelt und wenigstens einem Bestandteil der Kraftanlage zugeordnet wird.

Bei einem Bestandteil der Kraftanlage kann es sich auch um einen einzelnen Teil der Brennkraftmaschine, des Generators oder der Kupplungsvorrichtung handeln. So können auch Statorwicklungen, Rotorwicklungen oder eine Gleichrichterbrücke des Generators jeweils als Bestandteil der Kraftanlage angesehen werden.

Vorzugsweise kann vorgesehen sein, dass wenigstens einer der folgenden Zustandswerte von Betriebsgrößen der Kraftanlage ermittelt wird: das Auftreten einer Verzögerung des Zündzeitpunktes der Brennkraftmaschine, das Auftreten einer Unterbrechung der Verbrennung der Brennkraftmaschine, die Zeitdauer einer Unterbrechung der Verbrennung der Brennkraftmaschine, das Auftreten einer Abdrosselung eines Turboladers der Brennkraftmaschine, die Zeitdauer einer Abdrosselung des Turboladers der Brennkraftmaschine, die Höhe des Drehmoments an der Generatorwelle des Generators, die Höhe des Drehmoments an der Kupplungsvorrichtung, die Höhe des Drehmoments an der Motorwelle der Brennkraftmaschine, die Höhe der elektrischen Spannung des Generators, das Auftreten eines Spannungsabfalls des Generators, die Zeitdauer eines Spannungsabfalls des Generators, die Höhe des elektrischen Stroms des Generators, das Auftreten einer Stromstärkenerhöhung des Generators, die Zeitdauer einer Stromstärkenerhöhung des Generators, die Höhe der vom Generator an das Energieversorgungsnetz abgegebenen elektrischen Wirkleistung, die Höhe der Drehzahl der Generatorwelle des Generators, die Höhe der Drehzahl der Kupplungsvorrichtung, die Höhe der Drehzahl der Motorwelle der Brennkraftmaschine, die Höhe des Lastwinkels des Generators, die Höhe des Lastwinkels des Generators nach Behebung des Netzfehlers, die Höhe des Erregerstroms des Generators, die Zeitdauer einer bestimmten Erregerstromstärke des Generators.

In einer bevorzugten Variante kann vorgesehen sein, dass eine Mehrzahl von Fehlerwerten ermittelt wird.

In einer bevorzugten Ausführungsform der Erfindung kann vorgesehen sein, dass ein jeweiliger Fehlerwert einen von wenigstens zwei möglichen Werten aufweist, wobei vorzugsweise die wenigstens zwei möglichen Werte 0 und 1 sind.

Dabei kann vorgesehen sein, dass Fehlerwerte von einer oder mehreren der folgenden beispielhaften Betriebsgrößen in Abhängigkeit ihrer jeweiligen Zustandswerte ermittelt werden, wobei ein jeweiliger Fehlerwert entweder den Wert 0 oder den Wert 1 aufweist. Die Fehlerwerte sind dabei beispielhaft mit "N" und einer Zahl zur Unterscheidung der Fehlerwerte angegeben. Bei Fehlerwerten, die in Abhängigkeit vom Zustandswert und einem vorgebbaren Referenzwert bzw. Schwellwert ermittelt werden, ist der jeweilige Referenzwert bzw. Schwellwert beispielhaft mit "P" und einer Zahl zur Unterscheidung der Referenzwerte bzw. Schwellwerte angegeben.

Fehlerwerte von Betriebsgrößen in Bezug auf die Zündung der Brennkraftmaschine:
- N1:: Auftreten einer Verzögerung des Zündzeitpunktes
- N2:: Auftreten einer Unterbrechung der Verbrennung (zum Beispiel keine Zündung)
- N3:: Auftreten einer Unterbrechung der Verbrennung, wobei die Zeitdauer der Unterbrechung der Verbrennung mindestens P3 Millisekunden beträgt
- N4:: Auftreten einer Unterbrechung der Verbrennung, wobei die Zeitdauer der Unterbrechung der Verbrennung mindestens P4 Millisekunden beträgt

Fehlerwerte von Betriebsgrößen in Bezug auf den Turbolader der Brennkraftmaschine:
- N5:: Auftreten einer Abdrosselung des Turboladers
- N6:: Auftreten einer Abdrosselung des Turboladers, wobei die Zeitdauer der Abdrosselung des Turboladers mindestens P6 Millisekunden beträgt

Fehlerwerte von Betriebsgrößen in Bezug auf das Drehmoment an der Motorwelle der Brennkraftmaschine und/oder an der Kupplungsvorrichtung und/oder an der Generatorwelle des Generators:
- N7:: Das Drehmoment an der Kupplungsvorrichtung übersteigt ein erlaubtes Maximum von P7 kN*m oder per unit (p.u.)
- N8:: Das Drehmoment an der Kupplungsvorrichtung übersteigt ein erlaubtes Maximum von P8 kN*m oder p.u.

Fehlerwerte von Betriebsgrößen in Bezug auf die elektrische Spannung des Generators:
- N9:: Auftreten eines Spannungsabfalls des Generators auf unter P9 Prozent einer Nennausgangsspannung des Generators
- N10:: Auftreten eines Spannungsabfalls auf unter P9 Prozent, wobei die Zeitdauer des Spannungsabfalls auf unter P9 Prozent mindestens P10 Millisekunden beträgt
- N11:: Auftreten eines Spannungsabfalls auf unter P11 Prozent
- N12:: Auftreten eines Spannungsabfalls auf unter P11 Prozent, wobei die Zeitdauer des Spannungsabfalls auf unter P11 Prozent mindestens P12 Millisekunden beträgt
- N 13:: Auftreten von zwei aufeinanderfolgenden Spannungsabfällen auf unter P13a Prozent innerhalb P13b Sekunden

Fehlerwerte von Betriebsgrößen in Bezug auf den elektrischen Strom des Generators:
- N14:: Auftreten einer Stromstärkenerhöhung des Generators auf über P14 Ampere oder p.u.
- N15:: Auftreten einer Stromstärkenerhöhung des Generators auf über P14 Ampere oder p.u., wobei die Zeitdauer der Stromstärkenerhöhung auf mindestens P14 Ampere oder p.u. über P15 Millisekunden beträgt
- N16:: Auftreten einer Stromstärkenerhöhung des Generators auf über P16 Ampere oder p.u.
- N17:: Auftreten einer Stromstärkenerhöhung des Generators auf über P16 Ampere oder p.u., wobei die Zeitdauer der Stromstärkenerhöhung auf mindestens P16 Ampere oder p.u. über P17 Millisekunden beträgt
- N18:: Auftreten von zwei aufeinanderfolgenden Stromstärkenerhöhungen des Generators auf über P18a Ampere oder p.u. innerhalb P18b Sekunden

Fehlerwerte von Betriebsgrößen in Bezug auf die elektrische Wirkleistung des Generators:
- N19:: Auftreten einer Wirkleistung über P19 Kilowatt oder p.u.
- N20:: Auftreten einer Wirkleistung unter P20 Kilowatt oder p.u.

Fehlerwerte von Betriebsgrößen in Bezug auf die Drehzahl der Motorwelle der Brennkraftmaschine und/oder der Kupplungsvorrichtung und/oder der Generatorwelle des Generators:
- N21:: Auftreten einer Drehzahl über P21 Umdrehungen pro Minute
- N22:: Auftreten einer Drehzahl unter P22 Umdrehungen pro Minute

Fehlerwerte von Betriebsgrößen in Bezug auf den Lastwinkel des Generators:
- N23:: Auftreten eines Lastwinkels über P23 Grad
- N24:: Auftreten eines Lastwinkels unter P24 Grad
- N25:: Auftreten eines Lastwinkels über P25 Grad nachdem der Netzfehler behoben wurde
- N26:: Auftreten eines Lastwinkels oberhalb der Schlupfgrenze

Fehlerwerte von Betriebsgrößen in Bezug auf den Erregerstrom des Generators:
- N27:: Auftreten eines Erregerstroms über P27 Prozent eines Nennstroms des Generators
- N28:: Auftreten eines Erregerstroms über P27 Prozent für P28 Millisekunden

Es kann auch vorgesehen sein, dass ein Fehlerwert aus einer Verknüpfung von zwei oder mehreren anderen Fehlerwerten bzw. in Abhängigkeit von den Zustandswerten mehrere Betriebsgrößen ermittelt wird. Zum Beispiel kann vorgesehen sein, einen Fehlerwert für den Fall zu ermitteln, dass die Wirkleistung höher als P30 Kilowatt ist und der Lastwinkel über der Schlupfgrenze liegt:
- N29:: Auftreten einer Wirkleistung von über P30 Kilowatt und Auftreten eines Lastwinkels oberhalb der Schlupfgrenze

Erfindungsgemäß ist vorgesehen, dass abhängig vom wenigstens einen Fehlerwert ein Schweregrad des Netzfehlers ermittelt und/oder ausgegeben wird.

Es kann vorgesehen sein, dass abhängig von der Anzahl der Fehlerwerte mit einem vorgebbaren Wert ein Schweregrad des Netzfehlers ermittelt und ausgegeben wird, wobei vorzugsweise der vorgebbare Wert 1 ist. Es kann also beispielsweise vorgesehen sein, dass abhängig von der Anzahl der Fehlerwerte mit dem Wert 1 ein Netzfehler als leichter Netzfehler oder als schwerer Netzfehler eingestuft wird und abhängig von diesem Schweregrad des Netzfehlers entsprechende Wartungsempfehlungen ausgegeben werden. Durch das Feststellen und Ausgeben des Schwergrads eines Netzfehlers können qualitative Wartungsempfehlungen abgegeben werden, die im Unterschied zu bekannten Wartungsplänen nicht allein auf die Anzahl von aufgetretenen Netzfehlern abstellen, sondern den Schweregrad eines Netzfehlers berücksichtigen, indem festgestellt wird, ob es sich beim aufgetretenen Netzfehler um einen schwerwiegenden oder beispielsweise nur um einen geringfügigen Netzfehler handelte.

Es kann außerdem vorgesehen sein, dass das wenigstens eine Wartungssignal in Abhängigkeit vom Wert wenigstens eines Fehlerwertes ausgegeben wird. Für den Fall, dass ein Fehlerwert nur die zwei Werte 0 und 1 aufweisen kann, ermöglicht dies die besonders einfache Ermittlung eines auszugebenden Wartungssignals.

Die nachfolgende Tabelle 1 zeigt zwei Beispiele von Netzfehlern (einen leichten Netzfehler und einen schweren Netzfehler) und die davon hervorgerufenen Fehlerwerte von überwachten Betriebsgrößen in Abhängigkeit ihrer Zustandswerte und gegebenenfalls vorgegebener Referenzwerte. Die linke Spalte 1 der Tabelle bezeichnet dabei die jeweilige Betriebsgrößengruppe, Spalte 2 gibt die Fehlerwerte der jeweiligen Betriebsgröße der Betriebsgrößengruppe gemäß der vorangegangenen Beschreibung an, Spalte 3 gibt - wo angewandt - den jeweiligen Referenzwert zur Ermittlung des Fehlerwerts gemäß der vorangegangenen Beschreibung an, Spalte 4 zeigt den Wert des jeweiligen Fehlerwertes für das Beispiel des leichten Netzfehlers und Spalte 5 zeigt den Wert des jeweiligen Fehlerwertes für das Beispiel des schweren Netzfehlers. Beim leichten Netzfehler weisen sieben Fehlerwerte den Wert 1 auf und beim schweren Netzfehler weisen 22 Fehlerwerte den Wert 1 auf.

**Tabelle 1: Beispiele leichter Netzfehler und schwerer Netzfehler**

| Betriebsgrößengruppe | Fehlerwert | Referenzwert (wenn vorhanden) | Wert des Fehlerwerts (leichter Netzfehler) | Wert des Fehlerwerts (schwerer Netzfehler) |
|---|---|---|---|---|
| Zündung | N1 | | 0 | 0 |
| | N2 | | 1 | 1 |
| | N3 | P3 = 40 ms | 1 | 1 |
| | N4 | P4 = 120 ms | 0 | 1 |
| Turbolader | N5 | | 0 | 1 |
| | N6 | P6 = 50 ms | 0 | 0 |
| Drehmoment | N7 | P7= 9 kN*m (2 p.u.) | 1 | 1 |
| | N8 | P8 = 13,5 kN*m (3 p.u.) | 0 | 1 |
| Elektrische Spannung | N9 | P9 = 50 % | 1 | 1 |
| | N10 | P9 = 50 % | 0 | 0 |
| | | P10 = 150 ms | | |
| | N11 | P11 = 15 % | 0 | 1 |
| | N12 | P11 = 15 % | 0 | 0 |
| | | P12 = 150 ms | | |
| | N13 | P13a = 50 % | 0 | 0 |
| | | P13b = 3 s | | |
| Elektrischer Strom | N14 | P14 = 2000 A (2 p.u.) | 1 | 1 |
| | N15 | P14 = 2000 A (2 p.u.) | 1 | 1 |
| | | P15 = 5 ms | | |
| | N16 | P16 = 5000 A (5 p.u.) | 0 | 1 |
| | N17 | P16 = 5000 A (5 p.u.) | 0 | 1 |
| | | P17 = 5 ms | | |
| | N18 | P18a = 2000 A (2 p.u.) | 0 | 0 |
| | | P18b = 3 s | | |
| Elektrische Wirkleistung | N19 | P19 = 2 p.u. | 0 | 1 |
| | N20 | P20 = 2 p.u. | 0 | 1 |
| Drehzahl | N21 | P21 = 1600 Upm | 0 | 1 |
| | N22 | P22 = 1400 Upm | 0 | 1 |
| Lastwinkel | N23 | P23 = 120° | 0 | 1 |
| | N24 | P24 = -100° | 0 | 1 |
| | N25 | P25 = 100° (absolut) | 0 | 1 |
| | N26 | | 0 | 0 |
| Erregerstrom | N27 | P27 = 250 % | 1 | 1 |
| | N28 | P27 = 250 % | 0 | 1 |
| | | P28 = 200 ms | | |
| Verknüpfung von Betriebsgrößen | N29 | P30 = 2000 kW | 0 | 1 |

Gemäß einer besonders bevorzugten Ausführung kann vorgesehen sein, dass in Abhängigkeit vom wenigstens einen Fehlerwert und/oder dem Schweregrad des Netzfehlers ein Wartungssignal für wenigstens einen Bestandteil der Kraftanlage, vorzugsweise für den Generator und/oder die Brennkraftmaschine und/oder die Kupplungsvorrichtung, ausgegeben wird.

Die nachfolgende Tabelle 2 zeigt beispielhaft Wartungssignale für die Bestandteile Brennkraftmaschine, Kupplungsvorrichtung und Generator der Kraftanlage abhängig von Fehlerwerten gemäß der vorangegangenen Beschreibung. Ein Wartungssignal "Ja" in der Tabelle bedeutet in diesem Beispiel eine Wartungsempfehlung für den entsprechenden Bestandteil für den Fall, dass der jeweilige Fehlerwert den Wert 1 aufweist. Dementsprechend bedeutet ein Wartungssignal "Nein" in der Tabelle, dass für den entsprechenden Bestandteil keine Wartungsempfehlung in Bezug auf den jeweiligen Fehlerwert ausgegeben wird.

**Tabelle 2: Wartungssignale für Bestandteile der Kraftanlage**

| Fehlerwert (jeweiliger Wert = 1) | Wartungssignal für Brennkraftmaschine | Wartungssignal für Kupplung | Wartungssignal für Generator |
|---|---|---|---|
| N1 | Ja | Nein | Nein |
| N2 | Ja | Nein | Nein |
| N3 | Ja | Nein | Nein |
| N4 | Ja | Nein | Nein |
| N5 | Ja | Nein | Nein |
| N8 | Nein | Ja | Ja |
| N9 | Ja | Ja | Ja |
| N13 | Nein | Nein | Ja |
| N18 | Nein | Nein | Ja |
| N21 | Ja | Ja | Ja |
| N27 | Ja | Ja | Ja |
| N29 | Nein | Nein | Ja |
| N30 | Nein | Ja | Ja |

Bei einem Bestandteil der Kraftanlage kann es sich auch um einen einzelnen Teil der Brennkraftmaschine, des Generators oder der Kupplungsvorrichtung handeln. So können auch Statorwicklungen, Rotorwicklungen oder eine Gleichrichterbrücke des Generators jeweils als Bestandteil der Kraftanlage angesehen werden. Die nachfolgende Tabelle 3 zeigt beispielhaft Wartungssignale für die Bestandteile Statorwicklungen, Rotorwicklungen und Gleichrichterbrücke des Generators der Kraftanlage abhängig von Fehlerwerten gemäß der vorangegangenen Beschreibung. Ein Wartungssignal "Ja" in der Tabelle bedeutet in diesem Beispiel eine Wartungsempfehlung für den entsprechenden Bestandteil für den Fall, dass der jeweilige Fehlerwert den Wert 1 aufweist. Dementsprechend bedeutet ein Wartungssignal "Nein" in der Tabelle, dass für den entsprechenden Bestandteil keine Wartungsempfehlung in Bezug auf den jeweiligen Fehlerwert ausgegeben wird.

**Tabelle 3: Wartungssignale für Bestandteile des Generators der Kraftanlage**

| Fehlerwert (jeweiliger Wert = 1) | Wartungssignal für Statorwicklungen | Wartungssignal für Rotorwicklungen | Wartungssignal für Gleichrichterbrücke |
|---|---|---|---|
| N8 | Nein | Nein | Ja |
| N9 | Ja | Ja | Ja |
| N13 | Ja | Ja | Nein |
| N18 | Ja | Nein | Ja |
| N21 | Ja | Ja | Ja |
| N27 | Nein | Nein | Ja |
| N29 | Ja | Nein | Nein |
| N30 | Nein | Ja | Ja |

Vorzugsweise handelt es sich bei der Brennkraftmaschine um einen stationären Motor, insbesondere einen stationären Gasmotor.

Weitere Einzelheiten und Vorteile der vorliegenden Erfindung werden anhand der Figurenbeschreibung erläutert.

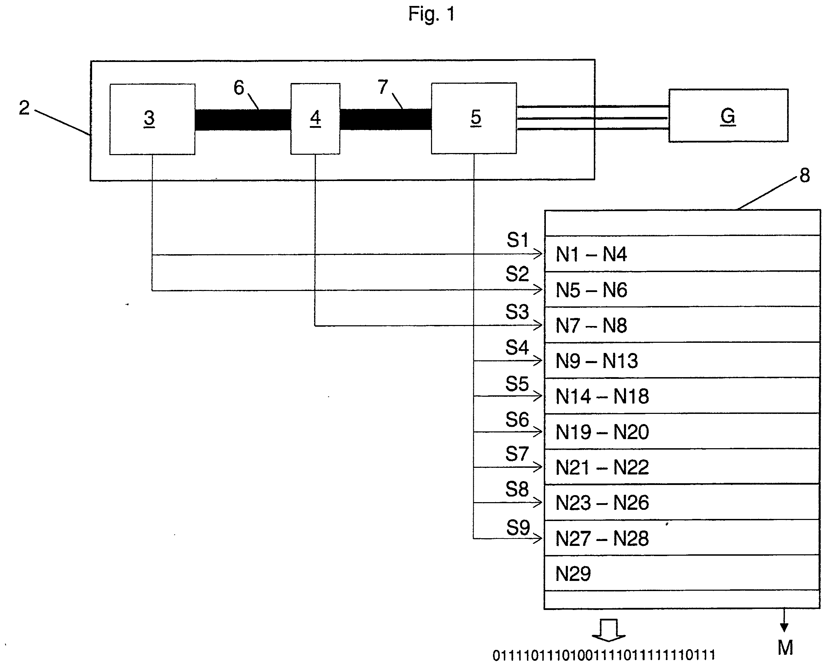

Figur 1 zeigt dabei in einem schematischen Blockschaltbild eine Kraftanlage 2, die eine Brennkraftmaschine 3, einen elektrischen Generator 5 sowie eine Kupplungsvorrichtung 4 zur Verbindung einer drehbar gelagerten Motorwelle 6 der Brennkraftmaschine 3 mit einer drehbar gelagerten Generatorwelle 7 des Generators 5 umfasst. Der elektrische Generator 5 der Kraftanlage 2 ist elektrisch mit einem Energieversorgungsnetz G verbunden. Das Energieversorgungsnetz G ist im vorliegenden Beispiel dreiphasig ausgeführt.

Um eine spezifische Wartungsempfehlung im Falle des Auftretens eines Netzfehlers, insbesondere eines elektrischen Kurzschlusses, im Energieversorgungsnetz G abgeben zu können, werden mehrere Betriebsgrößen der Kraftanlage 2 überwacht. Insbesondere werden bei Auftreten eines Netzfehlers im Energieversorgungsnetz G Zustandswerte S1 bis S9 von verschiedenen Betriebsgrößen der Bestandteile Brennkraftmaschine 3, Kupplungsvorrichtung 4 und Generator 5 der Kraftanlage 2 ermittelt und an eine Überwachungsvorrichtung 8 gemeldet. Bei den Zustandswerten S1 bis S9 von Betriebsgrößen der Kraftanlage 2 kann es sich beispielsweise um das Auftreten einer Verzögerung des Zündzeitpunktes der Brennkraftmaschine 3, um die Höhe des Drehmoments an der Kupplungsvorrichtung 4 oder um die Höhe des Lastwinkels des Generators 5 handeln.

Die Überwachungsvorrichtung 8 ermittelt in Abhängigkeit von den gemeldeten Zustandswerten S1 bis S9 der Betriebsgrößen der Kraftanlage 2 Fehlerwerte N1 bis N29, gegebenenfalls unter Einsatz von vorgebbaren Referenzwerten für die Zustandswerte S1 bis S9. Im vorliegenden Fall ermittelt die Überwachungsvorrichtung 8 aus dem gemeldeten Zustandswert S1 beispielsweise die vier Fehlerwerte N1 bis N4. Beispiele für die Ermittlung der Fehlerwerte N1 bis N29 sind in der vorangegangenen Beschreibung angeführt.

Dabei ist im vorliegenden Beispiel vorgesehen, dass ein jeweiliger Fehlerwert N1 bis N29 einen von zwei möglichen Werten aufweist. So kann ein Fehlerwert N1 bis N29 entweder den Wert 0 oder den Wert 1 aufweisen, wobei in diesem Beispiel ein Fehlerwert N1 bis N29 den Wert 1 aufweist, wenn ein Fehler vorliegt und den Wert 0 aufweist, wenn kein Fehler vorliegt. Die einzelnen Fehlerwerte N1 bis N29 können von der Überwachungsvorrichtung 8 auch ausgegeben werden. Dies ist in der Abbildung durch die Zahlenfolge gebildet aus den Werten 0 und 1 angedeutet. Im vorliegenden Fall weisen also insgesamt 22 der Fehlerwerte N1 bis N29 jeweils den Wert 1 auf, sodass es insgesamt 22 Fehlermeldungen gibt.

Die von der Überwachungsvorrichtung 8 ermittelten Fehlerwerte N1 bis N29 werden jeweils einem Bestandteil der Kraftanlage 2 zugeordnet, wobei als Bestandteile der Kraftanlage 2 die Brennkraftmaschine 3, die Motorwelle 6, die Kupplungsvorrichtung 4, die Generatorwelle 7 und der Generator 5 angesehen werden können. Bei einem Bestandteil der Kraftanlage 2 kann es sich aber auch um einen einzelnen Teil der Brennkraftmaschine 3, des Generators 5 oder der Kupplungsvorrichtung 4 handeln.

Abhängig von der Zuordnung eines Fehlerwerts N1 bis N29 zu einem Bestandteil der Kraftanlage 2 wird in Abhängigkeit vom jeweiligen Fehlerwert N1 bis N 29 ein Wartungssignal M für den entsprechenden Bestandteil der Kraftanlage 2 ausgegeben. So kann im gezeigten Beispiel vorgesehen sein, dass der Fehlerwert N1 dem Bestandteil Brennkraftmaschine 3 der Kraftanlage 2 zugeordnet ist, wobei ein Wartungssignal M ausgegeben wird, wenn der Fehlerwert N1 den Wert 1 aufweist. Es kann beispielsweise auch vorgesehen sein, dass der Fehlerwert N21 den Bestandteilen Brennkraftmaschine 3, Kupplungsvorrichtung 4 und Generator 5 zugeordnet ist und dass ein Wartungssignal M für alle diese Bestandteile 3, 4, 5 ausgegeben wird, falls der Fehlerwerts N21 den Wert 1 aufweist. Beispiele für Zuordnungen von Fehlerwerten N1 bis N 29 zu Bestandteilen 3, 4, 5 der Kraftanlage 2 sind in der vorangegangenen Beschreibung in den Tabellen 2 und 3 angegeben.

## Patentansprüche

1. Verfahren zum Betreiben einer mit einem Energieversorgungsnetz (G) verbundenen stationären Kraftanlage (2), wobei bei Auftreten eines dynamischen Netzfehlers im Energieversorgungsnetz (G), insbesondere eines elektrischen Kurzschlusses, wenigstens ein Fehlerwert (N1 - N29) in Abhängigkeit von einem Zustandswert (S1 - S9) wenigstens einer Betriebsgröße der Kraftanlage (2) ermittelt wird, **dadurch gekennzeichnet, dass** der wenigstens eine Fehlerwert (N1 - N29) wenigstens einem Bestandteil (3, 4, 5) der Kraftanlage (2) zugeordnet wird, wobei ein Wartungssignal (M) für den wenigstens einen Bestandteil (3, 4, 5) der Kraftanlage (2) in Abhängigkeit vom wenigstens einen Fehlerwert (N1 - N29) ausgegeben wird, wobei abhängig vom wenigstens einen Fehlerwert (N1 - N29) ein Schweregrad des Netzfehlers ermittelt und/oder ausgegeben wird.

2. Verfahren nach Anspruch 1, **dadurch gekennzeichnet, dass** das Energieversorgungsnetz (G) ein öffentliches Stromnetz ist.

3. Verfahren nach Anspruch 1, **dadurch gekennzeichnet, dass** das Energieversorgungsnetz (G) ein Inselnetz ist.

4. Verfahren nach wenigstens einem der Ansprüche 1 bis 3, **dadurch gekennzeichnet, dass** zur Ermittlung des wenigstens einen Fehlerwerts (N1 - N29) der Zustandswert (S1 - S9) der wenigstens einen Betriebsgröße der Kraftanlage (2) vor dem Netzfehler und/oder während des Netzfehlers und/oder nach dem Netzfehler ermittelt wird.

5. Verfahren nach wenigstens einem der Ansprüche 1 bis 4, **dadurch gekennzeichnet, dass** der Fehlerwert (N1 - N29) in Abhängigkeit vom Zustandswert (S1 - S9) der wenigstens einen Betriebsgröße und wenigstens einem vorgebbaren Referenzwert ermittelt wird.

6. Verfahren nach wenigstens einem der Ansprüche 1 bis 5, **dadurch gekennzeichnet, dass** die Kraftanlage (2) wenigstens einen der folgenden Bestandteile umfasst: einen mit dem Energieversorgungsnetz (G) verbundenen elektrischen Generator (5), eine mit dem Generator (5) verbundene Brennkraftmaschine (3), eine Kupplungsvorrichtung (4) zur Verbindung einer drehbar gelagerten Generatorwelle (7) des Generators (5) mit einer drehbar gelagerten Motorwelle (6) der Brennkraftmaschine (3), wobei wenigstens ein Fehlerwert (N1 - N29) in Abhängigkeit von einem Zustandswert (S1 - S9) wenigstens einer Betriebsgröße des Generators (5) und/oder der Brennkraftmaschine (3) und/oder der Kupplungsvorrichtung (4) ermittelt und wenigstens einem Bestandteil der Kraftanlage (2) zugeordnet wird.

7. Verfahren nach Anspruch 6, **dadurch gekennzeichnet, dass** wenigstens einer der folgenden Zustandswerte (S1 - S9) von Betriebsgrößen der Kraftanlage (2) ermittelt wird: das Auftreten einer Verzögerung des Zündzeitpunktes der Brennkraftmaschine (3), das Auftreten einer Unterbrechung der Verbrennung der Brennkraftmaschine (3), die Zeitdauer einer Unterbrechung der Verbrennung der Brennkraftmaschine (3), das Auftreten einer Abdrosselung eines Turboladers der Brennkraftmaschine (3), die Zeitdauer einer Abdrosselung des Turboladers der Brennkraftmaschine (3), die Höhe des Drehmoments an der Generatorwelle (7) des Generators (5), die Höhe des Drehmoments an der Kupplungsvorrichtung (4), die Höhe des Drehmoments an der Motorwelle (6) der Brennkraftmaschine (3), die Höhe der elektrischen Spannung des Generators (5), das Auftreten eines Spannungsabfalls des Generators (5), die Zeitdauer eines Spannungsabfalls des Generators (5), die Höhe des elektrischen Stroms des Generators (5), das Auftreten einer Stromstärkenerhöhung des Generators (5), die Zeitdauer einer Stromstärkenerhöhung des Generators (5), die Höhe der vom Generator (5) an das Energieversorgungsnetz (G) abgegebenen elektrischen Wirkleistung, die Höhe der Drehzahl der Generatorwelle (7) des Generators (5), die Höhe der Drehzahl der Kupplungsvorrichtung (4), die Höhe der Drehzahl der Motorwelle (6) der Brennkraftmaschine (3), die Höhe des Lastwinkels des Generators (5), die Höhe des Lastwinkels des Generators (5) nach Behebung des Netzfehlers, die Höhe des Erregerstroms des Generators (5), die Zeitdauer einer bestimmten Erregerstromstärke des Generators (5).

8. Verfahren nach wenigstens einem der Ansprüche 1 bis 7, **dadurch gekennzeichnet, dass** eine Mehrzahl von Fehlerwerten (N1 - N29) ermittelt wird.

9. Verfahren nach wenigstens einem der Ansprüche 1 bis 8, **dadurch gekennzeichnet, dass** in Abhängigkeit vom wenigstens einen Fehlerwert (N1 - N29) und/oder dem Schweregrad des Netzfehlers ein Wartungssignal (M) für wenigstens einen Bestandteil (3, 4, 5) der Kraftanlage (2), vorzugsweise für den Generator (5) und/oder die Brennkraftmaschine (3) und/oder die Kupplungsvorrichtung (4), ausgegeben wird.

10. Verfahren nach wenigstens einem der Ansprüche 1 bis 9, **dadurch gekennzeichnet, dass** ein jeweiliger Fehlerwert (N1 - N29) einen von wenigstens zwei möglichen Werten aufweist, wobei vorzugsweise die wenigstens zwei möglichen Werte 0 und 1 sind.

11. Verfahren nach Anspruch 10, **dadurch gekennzeichnet, dass** das wenigstens eine Wartungssignal (M) in Abhängigkeit vom Wert wenigstens eines Fehlerwertes (N1 - N29) ausgegeben wird.

12. Verfahren nach Anspruch 10 oder 11, **dadurch gekennzeichnet, dass** abhängig von der Anzahl der Fehlerwerte (N1 - N29) mit einem vorgebbaren Wert ein Schweregrad des Netzfehlers ermittelt und ausgegeben wird, wobei vorzugsweise der vorgebbare Wert 1 ist.

## Claims

1. A method of operating a stationary power plant (2) connected to a power supply network (G), wherein upon the occurrence of a dynamic network fault in the power supply network (G), in particular an electric short-circuit, at least one fault value (N1 - N29) is ascertained in dependence on a state value (S1 - S9) of at least one operating parameter of the power plant (2) **characterised in that** the at least one fault value (N1 - N29) is associated with at least one component (3, 4, 5) of the power plant (2), wherein a maintenance signal (M) for the at least one component (3, 4, 5) of the power plant (2) is output in dependence on the at least one fault value (N1 - N29), wherein a degree of severity of the network fault is ascertained and/or output in dependence on the at least one fault value (N1 - N29).

2. A method as set forth in claim 1 **characterized in that** the power supply network (G) is a public grid.

3. A method as set forth in claim 1 **characterized in that** the power supply network (G) is an island network.

4. A method as set forth in at least one of the claims through 3 **characterized in that** to ascertain the at least one fault value (N1 - N29) the state value (S1 - S9) of the at least one operating parameter of the power plant (2) is ascertained prior to the network fault and/or during the network fault and/or after the network fault.

5. A method as set forth in at least one of the claims 1 through 4 **characterized in that** the fault value (N1 - N29) is ascertained in dependence on the state value (S1 - S9) of the at least one operating parameter and at least one predeterminable reference value.

6. A method as set forth in at least one of the claims 1 through 5 **characterized in that** the power plant (2) includes at least one of the following components: an electric generator (5) connected to the power supply network (G), an internal combustion engine (3) connected to the generator (5), a coupling device (4) for connecting a rotatably mounted generator shaft (7) of the generator (5) to a rotatably mounted engine shaft (6) of the internal combustion engine (3), wherein at least one fault value (N1 - N29) is ascertained in dependence on a state value (S1 - S9) of at least one operating parameter of the generator (5) and/or the internal combustion engine (3) and/or the coupling device (4) and is associated with at least one component of the power plant (2).

7. A method as set forth in claim 6 **characterised in that** at least one of the following state values (S1 - S9) of operating parameters of the power plant (2) is ascertained: the occurrence of a delay in the ignition time of the internal combustion engine (3), the occurrence of an interruption in combustion of the internal combustion engine (3), the duration of an interruption in combustion of the internal combustion engine (3), the occurrence of a throttling of a turbocharger of the internal combustion engine (3), the duration of a throttling of the turbocharger of the internal combustion engine (3), the level of the torque at the generator shaft (7) of the generator (5), the level of the torque at the coupling device (4), the level of the torque at the engine shaft (6) of the internal combustion engine (3), the level of the electric voltage of the generator (5), the occurrence of a voltage drop at the generator (5), the duration of a voltage drop at the generator (5), the level of the electric current of the generator (5), the occurrence of an increase in current strength of the generator (5), the duration of an increase in current strength of the generator (5), the level of the electrical active power delivered by the generator (5) to the power supply network (G), the level of the rotary speed of the generator shaft (7) of the generator (5), the level of the rotary speed of the coupling device (4), the level of the rotary speed of the engine shaft (6) of the internal combustion engine (3), the level of the load angle of the generator (5), the level of the load angle of the generator (5) after elimination of the network fault, the level of the exciter current of the generator (5) and the duration of a given exciter current strength of the generator (5).

8. A method as set forth in at least one of claims 1 through 7 **characterised in that** a plurality of fault values (N1 - N29) is ascertained.

9. A method as set forth in at least one of the claims 1 through 9 **characterised in that** a maintenance signal (M) for at least one component (3, 4, 5) of the power plant (2), preferably for the generator (5) and/or the internal combustion engine (3) and/or the coupling device (4) is output in dependence on at least one fault value (N1 - N29) and/or the degree of severity of the network fault.

10. A method as set forth in one of claims 1 through 9 **characterised in that** a respective fault value (N1 - N29) has one of at least two possible values, wherein preferably the at least two possible values are 0 and 1.

11. A method as set forth in claim 10 **characterised in that** the at least one maintenance signal (M) is output in dependence on the value of at least one fault value (N1 - N29).

12. A method as set forth in claim 10 or claim 11 **characterised in that** a degree of severity of the network fault is ascertained and output in dependence on the number of fault values (N1 - N29) of a predeterminable value, wherein preferably the predeterminable value is 1.

## Revendications

1. Procédé pour faire fonctionner une centrale électrique fixe (2) reliée à un réseau d'alimentation en énergie (G), dans lequel lors de l'apparition d'une défaillance dynamique du réseau dans le réseau d'alimentation en énergie (G), plus particulièrement d'un court-circuit électrique, au moins une valeur d'erreur (N1 - N29) est déterminée en fonction d'une valeur d'état (S1 - S9) au moins d'une grandeur de fonctionnement de la centrale électrique (2), **caractérisé en ce que** la au moins une valeur d'erreur (N1 - N29) est affectée à au moins une partie constitutive (3, 4, 5) de la centrale électrique (2), dans lequel un signal de maintenance (M) pour la au moins une partie constitutive (3, 4, 5) de la centrale électrique (2) est émis en fonction d'au moins une valeur d'erreur (N1 - N29), dans lequel en fonction d'au moins une valeur d'erreur (N1 - N29) un degré de gravité de la défaillance du réseau est déterminé et / ou donné.

2. Procédé selon la revendication 1, **caractérisé en ce que** le réseau d'alimentation en énergie (G) est un réseau électrique public.

3. Procédé selon la revendication 1, **caractérisé en ce que** le réseau d'alimentation en énergie (G) est un réseau indépendant.

4. Procédé selon au moins l'une des revendications 1 à 3, **caractérisé en ce que** pour déterminer la au moins une valeur d'erreur (N1 - N29), la valeur d'état (S1 - S9) de la au moins une grandeur de fonctionnement de la centrale électrique (2) est déterminée avant la défaillance du réseau et / ou pendant la défaillance du réseau et / ou après la défaillance du réseau.

5. Procédé selon au moins l'une des revendications 1 à 4, **caractérisé en ce que** la valeur d'erreur (N1 - N29) est déterminée en fonction de la valeur d'état (S1 - S9) de la au moins une grandeur de fonctionnement et de la au moins une valeur de référence pouvant être prédéfinie.

6. Procédé selon au moins l'une des revendications 1 à 5, **caractérisé en ce que** la centrale électrique (2) comprend au moins l'une des parties constitutives suivantes : un générateur électrique (5) relié au réseau d'alimentation en énergie (G), un moteur à combustion interne (3) relié au générateur (5), un dispositif d'accouplement (4) pour relier un arbre de générateur (7), logé de façon rotative, du générateur (5) à un arbre du moteur, logé de façon rotative, du moteur à combustion interne (3), dans lequel au moins une valeur d'erreur (N1 - N29) est déterminée en fonction d'une valeur d'état (S1 - S9) au moins d'une grandeur de fonctionnement du générateur (5) et / ou du moteur à combustion interne (3) et / ou du dispositif d'accouplement (4) et est affectée à au moins une partie constitutive de la centrale électrique (2).

7. Procédé selon la revendication 6, **caractérisé en ce qu'**au moins une des valeurs d'état suivantes (S1 - S9) est déterminée par les grandeurs de fonctionnement de la centrale électrique (2) : l'apparition d'un retard du moment d'allumage du moteur à combustion interne (3), l'apparition d'une interruption de la combustion du moteur à combustion interne (3), la durée d'une interruption de la combustion du moteur à combustion interne (3), l'apparition d'un étranglement d'un turbocompresseur du moteur à combustion interne (3), la durée d'un étranglement du turbocompresseur du moteur à combustion interne(3), le niveau du couple de rotation à l'arbre de générateur (7) du générateur (5), le niveau du couple de rotation au dispositif d'accouplement (4), le niveau du couple de rotation à l'arbre du moteur (6) du moteur à combustion interne (3), le niveau de la tension électrique du générateur (5), l'apparition d'une chute de tension du générateur (5), la durée d'une chute de tension du générateur (5), le niveau du courant électrique du générateur (5), l'apparition d'une augmentation de l'intensité de courant du générateur (5), la durée d'une augmentation de l'intensité de courant du générateur (5), le niveau de la puissance active électrique délivrée par le générateur (5) au réseau d'alimentation en énergie (G), le niveau de la vitesse de rotation de l'arbre de générateur (7) du générateur (5), le niveau de la vitesse de rotation du dispositif d'accouplement (4), le niveau de la vitesse de rotation de l'arbre du moteur (6) du moteur à combustion interne (3), le niveau de l'angle de charge du générateur (5), le niveau de l'angle de charge du générateur (5)après suppression de la défaillance du réseau, le niveau du courant d'excitation du générateur (5), la durée d'une certaine intensité de courant d'excitation du générateur (5).

8. Procédé selon au moins l'une des revendications 1 à 7, **caractérisé en ce qu'**une pluralité de valeurs d'erreur (N1 - N29) est déterminée.

9. Procédé selon au moins l'une des revendications 1 à 8, **caractérisé en ce qu'**en fonction d'au moins une valeur d'erreur (N1 - N29) et / ou du degré de gravité de la défaillance du réseau, un signal de maintenance (M) pour au moins une partie constitutive (3, 4, 5) de la centrale électrique (2), de préférence pour le générateur (5) et / ou le moteur à combustion interne (3) et / ou le dispositif d'accouplement (4) est délivré.

10. Procédé selon au moins l'une des revendications 1 à 9, **caractérisé en ce qu'**une valeur d'erreur respective (N1 - N29) présente une de au moins deux valeurs possibles, dans lequel les au moins deux valeurs possibles sont de préférence 0 et 1.

11. Procédé selon la revendication 10, **caractérisé en ce que** le au moins un signal de maintenance (M) est délivré en fonction de la valeur d'au moins une valeur d'erreur (N1 - N29).

12. Procédé selon la revendication 10 ou 11, **caractérisé en ce qu'**en fonction du nombre de valeurs d'erreur (N1 - N29) avec une valeur pouvant être prédéfinie un degré de gravité de la défaillance du réseau est déterminé et donné, dans lequel la valeur pouvant être prédéfinie est de préférence 1.
